# EUROPEAN PATENT APPLICATION

(11) **EP 2 927 346 A1**
(43) Date of publication of application: **07.10.2015**
(21) Application number: 13857896.8
(22) Date of filing: 29.11.2013
(51) Int. Cl.: C23C 26/00

(54) **COATING METHOD FOR REDUCING DAMAGE TO BARRIER LAYER**

(30) Priority: 29.11.2012 KR 20120137345; 30.11.2012 KR 20120138316
(71) Applicant: LG Chem, Ltd., Seoul 150-721 (KR)
(72) Inventor: KIM, Dong Ryul, Daejeon 305-738 (KR); HWANG, Jang Yeon, Daejeon 305-738 (KR); LEE, Seong Hwan, Daejeon 305-738 (KR); RYU, Sang Uk, Daejeon 305-738 (KR); KIM, Joon Hyung, Daejeon 305-738 (KR); SON, Beom Gwon, Daejeon 305-738 (KR); LEE, Hyun Ji, Daejeon 305-738 (KR)
(74) Representative: Goddar, Heinz J.
(86) International application number: PCT/KR2013/011040
(87) International publication number: WO 2014/084685

(57) **Abstract**

A coating method which reduces damage of a barrier layer is provided. The barrier film has a gas barrier property improved by suppressing reduction of a water vapor transmittance rate through a non-contact coating method on a barrier layer when a protective coating is performed to protect a barrier layer of the barrier film.

## Description

### CROSS-REFERENCE TO RELATED APPLICATION

This application claims priority to and the benefit of Korean Patent Application Nos. 2012-0137345, 2012-0138316 and 2013-0147836, filed November 29, 2012, November 30, 2012 and November 29, 2013, respectively, the disclosure of which is incorporated herein by reference in its entirety.

### BACKGROUND

### 1. Field of the Invention

The present application relates to a coating method capable of inhibiting reduction of a water transmission rate by performing a non-contact coating method on a barrier layer when protective coating is performed to protect a barrier layer of a barrier film.

### 2. Discussion of Related Art

A gas barrier film, that is, a barrier film, has a gas barrier property because a barrier layer having a thickness of about tens or 100 nm is stacked. Examples of a method of forming the barrier layer include atomic layer deposition(ALD). This method is used to form a metal barrier layer in a semiconductor device, a wear resistant film, or a corrosion resistant film because it has good thickness uniformity, film density, and conformality. In the field of semiconductors, atomic layer deposition(ALD) is generally performed on a deposition substrate made of inorganic materials such as a silicon wafer. Water molecules are adsorbed onto the surfaces of these inorganic materials to naturally form hydroxyl groups, and then the hydroxyl groups react with organometals, and thus a homogeneous oxide film with good adhesion may be stacked by atomic layer deposition(ALD). For example, an Al₂O₃ deposition process may be represented by the following Reaction 1. As known in Reaction 1(a), when a density of a hydroxyl group is increased on the surface of a substrate, adhesion between a deposition layer and the substrate is increased, durability of a composite stacking body is improved, and thus a denser barrier layer is formed on the surface:
Reaction 1

   (a): substrate-OH + Al(CH₃)₃ → substrate-O-Al(CH₃)₂ + CH₄

   (b): substrate-O-Al(CH₃)₂ + 2H₂O → substrate-O-Al(OH)₂ + 2CH₄

However, when the film is damaged because a thickness of the barrier layer is very small, a gas barrier property is decreased significantly. Accordingly, the barrier layer should be protected by a coating layer to suppress reduction of a gas barrier property.

### SUMMARY OF THE INVENTION

The present application is directed to a barrier film capable of protecting products which are likely to be deteriorated by water during general use, such as display devices or photovoltaic elements; a method of preparing a barrier film in which, when a protective layer protecting a thin inorganic layer, that is, a barrier layer, formed on a substrate by atomic layer deposition(ALD) is formed, the protective layer is formed in such a way that contact with the barrier layer is minimized using a non-contact coating method, and thus damage of the barrier layer and reduction of a gas barrier property are prevented; and a barrier film forming apparatus.

According to an aspect of the present application, there is provided a method of preparing a barrier film including forming a barrier layer and a protective layer on a substrate layer. An exemplary method of preparing the barrier film may include forming the barrier layer on a substrate layer by atomic layer deposition(ALD) and coating the barrier layer with a coating composition by a non-contact coating method to form the protective layer.

Hereinafter, the present application will be described in detail.

The barrier film of the present application is formed by forming a thin barrier layer on a substrate layer by atomic layer deposition(ALD), and forming a protective layer using a non-contact coating method which minimizes contact with the barrier layer when the protective layer protecting the barrier layer is formed. Thus damage of the barrier layer is prevented, and reduction of a gas barrier property is suppressed.

The barrier layer of the barrier film of the present application may be formed above or below the substrate layer, and may be used by attaching two sheets of composite films.

Examples of the substrate layer may include a metal oxide substrate, a semiconductor substrate, a glass substrate, a plastic substrate, and the like.

The substrate layer may be a monolayer, or a multilayer of two or more layers of the same or different kinds.

Also, the surface of the substrate layer may be subjected to corona treatment, normal pressure plasma treatment, or adhesive primer treatment to enable adhesion.

According to the present application, an intermediate layer may be further formed on the substrate layer.

The intermediate layer flattens the surface of the substrate layer having a surface roughness of tens to hundreds of nanometers. The intermediate layer uniformly distributes a functional group which is easily reacted with organometals on the surface of the substrate layer so that organometals to be used for atomic layer deposition(ALD) may be uniformly adsorbed onto the surface of the substrate layer. Accordingly, the intermediate layer may have, for example, a thickness of 0.1 nm to 10 nm or 0.3 µm to 2 µm. As the intermediate layer has the aforementioned thickness range, the rough surface of a commercially available substrate layer is covered by the intermediate layer and flattened, thus preventing locally concentrated stress. Accordingly, cracks may minimally occur in bending, heat shrinking or expansion, and then improve durability of a composite film.

The intermediate layer may be optionally disposed on either or both surfaces of a primerized substrate. The intermediate layer may be one of an organic material and mixture of organic and inorganic materials.

The intermediate layer is conventionally formed of a coating composition including (i) a photoinitiator; (ii) a low molecular reactive diluent (for example, monomer acrylate); (iii) an unsaturated oligomer (for example, acrylate, urethane acrylate, polyether acrylate, epoxy acrylate, or polyester acrylate); and (iv) a solvent. Such a coating composition is cured by a free radical reaction which is initiated according to a photodegradable route. A blend of respective components may be changed depending on desired final features. In one embodiment, a coating composition forming the intermediate layer includes a UV-curable mixture of a monomer and an oligomer acrylate (preferably including methyl methacrylate and ethyl acrylate) in a solvent (for example, methyl ethyl ketone), in which the coating composition conventionally includes an acrylate in a solid content of 20 to 30 wt% based on the total weight of the composition, and further includes a small amount (for example, about 1 wt% of solid content) of a photoinitiator (for example, Irgacure™ 2959, manufactured by Ciba).

The term "lower molecular weight" described herein refers to a polymerizable monomer species. The term "reactive" refers to polymerizability of monomer species.

An coating composition includes a crosslinkable organic polymer (for example, polyethylene imine (PEI), polyester, polyvinyl alcohol (PVOH), polyamide, polythiol, or polyacrylic acid) and a crosslinking agent (for example, Cymel™ 385 or those described herein) in a solvent (a general aqueous solvent). The coating composition preferably includes PEI (preferably, with a molecular weight (Mw) in a range of 600,000 to 900,000).

Other examples of the intermediate layer are disclosed in US4198465, US3708225, US4177315, US4309319, US4436851, US4455205, US0142362, WO2003/087247 and EP1418197.

A coating composition of the intermediate layer may be applied continuously or using coating methods including a dip coating process. Coating is generally applied to have a thickness after drying of about 1 to 20 µm, preferably 2 to 10 µm, more preferably 3 to 10 µm. A coating composition may be applied in an "off-line" mode that is a different process from a film preparation process or an "in-line" mode in which a film preparation process is continuously performed. Coating is preferably performed in the in-line mode. The thermosetting coating composition after applied on a substrate layer may be cured at about 20 to 200 °C, and preferably about 20 to 150 °C. Whereas the coating composition may be cured for several days at room temperature of 20 °C, or may be cured for several seconds at a heating temperature of 150 °C.

The barrier layer is deposited on the intermediate layer. Thus, when the intermediate layer is not flattened, defects may occur during deposition of the barrier layer so that a gas barrier property is decreased. When flatness of the surface is decreased, a gas barrier property is increased. Accordingly, flatness of the intermediate layer may have Ra of less than 0.7 nm, preferably less than 0.6 nm, more preferably less than 0.5 nm, even more preferably less than 0.4 nm, even more preferably less than 0.3 nm, and ideally less than 0.25 nm, and/or Rq of less than 0.9 nm, preferably less than 0.8 nm, more preferably less than 0.75 nm, even more preferably less than 0.65 nm, even more preferably less than 0.6 nm, even more preferably less than 0.50 nm, even more preferably less than 0.45 nm, even more preferably less than 0.35 nm, and ideally less than 0.3 nm.

The surface of the intermediate layer maybe subjected to plasma pretreatment before deposition of the barrier layer. Plasma pretreatment may be generally performed under argon/nitrogen or argon/oxygen atmosphere for about 2 to 8 minutes, preferably about 5 minutes. Specifically, plasma pretreatment is microwave-activated. In other words, plasma pretreatment is performed using microwave plasma generation source without another plasma generation source.

A gas barrier layer is formed on the intermediate layer by chemical bonds with functional groups, and therefore a peeling problem which is likely to occur in a multilayer composite film may be solved.

In order to prepare a barrier film of the present application, the barrier layer is formed on the surface of the substrate layer.

The barrier layer provides a sufficient barrier property to obtain water vapor and/or oxygen transmittance, and specifically, a water vapor transmittance rate is less than 10⁻³ g/m²/day and an oxygen transmittance rate is less than 10⁻³ g/m²/day. Specifically, the water vapor transmittance rate is less than 10⁻⁴ g/m²/day, preferably less than 10⁻⁵ g/m²/day, and more preferably less than 10⁻⁶ g/m²/day. Oxygen transmittance rate is less than 10⁻⁴ g/m²/day or less than 10⁻⁵ g/m²/day.

The barrier layer is formed by atomic layer deposition(ALD). The ALD is self-limiting sequential surface chemistry which allows a conformal thin film of materials to be deposited on a substrate in an atomic level. A film generated by ALD is formed layer-wise, and an atomic layer of a generated superfine film is controlled to about 0.1 Å per monolayer. The total thickness of the deposited film is typically about 1 to 500 nm. Coating may be performed by ALD at a uniform thickness inside a deep trench, inside a porous medium, and around of particles. An ALD-growth film is chemically bonded to a substrate layer. Description of an ALD process is described in detail in "Atomic Layer Epitaxy" by Tuomo Suntola in Thin Solid Films, vol. 216 (1992) pp. 84-89. While precursor materials are maintained separately during coating process and reaction, ALD is chemically similar to chemical vapor deposition (CVD) except that a CVD reaction is split into two half reactions in ALD. During the process, precursor vapor is absorbed into a substrate layer in a vacuum chamber. Subsequently, the vapor is pumped from the chamber, and a thin layer (barrier layer) formed of the absorbed precursor is deposited on the substrate layer. Subsequently, reactants are introduced into the chamber under a thermal condition which accelerates a reaction with the absorbed precursor such that a layer of target materials is formed. Reaction byproducts are pumped from the chamber. The substrate may be exposed again to precursor vapor and the deposition processes may be performed repeatedly to form a subsequent layer of the material. ALD is different from conventional CVD and physical vapor deposition (PVD) which is performed after growth is initiated on a limited number of nuclear forming portions on the surface of the substrate layer. CVD and PVD technologies may derive column growth having a granular fine structure, showing a boundary in which a gas easily permeates between columns. An ALD process includes a nondirectional growth mechanism to obtain a fine structure having no characterization part. Suitable materials for a barrier layer which is formed by ALD in the present application are inorganic materials and include oxides, nitrides, and sulfides of groups IVB, VB, VIB, IIIA, IIB, IVA, VA and VIA of the periodic table, and combinations thereof. Specifically, oxides, nitrides, or mixtures of oxides and nitrides are preferable. Oxides show good optical transparency to electronic displays and photovoltaic cells, such that visible rays are discharged from the element or enter the element, and nitrides of Si and Al are transparent in the visible spectrum. For example, SiO₂, Al₂O₃, ZnO, ZnS, HfO₂, HfON, AlN, Si₃N₄, SiON, SnO₂, and the like can be used.

Precursors which are used for the ALD process to form such barrier materials are known widely (for example, see M. Leskela and M. Ritala, "ALD precursor chemistry: Evolution and future challenges," Journal de Physique IV, vol. 9, pp 837-852 (1999) and references cited therein). A temperature of a substrate layer preferable for synthesis of a barrier coating by ALD is 50 to 250 °C. Since dimensional changes of the substrate layer cause chemical decomposition or collapse of ALD coating, it is not preferable for the temperature to exceed 250 °C.

A thickness of the barrier layer may be 2 to 100 nm, 2 to 50 nm, or 2 to 20 nm. When a thickness of the layer is decreased, the film may endure bending without generation of cracks.

The protective layer in the present application may be formed on the aforementioned barrier layer by a non-contact coating method.

Examples of the non-contact coating method include inkjet coating, capillary coating, slot die coating, plasma polymerization coating, sputtering coating, evaporation coating, CVD coating, iCVD coating, and the like.

The protective layer is formed by coating the barrier layer with a coating composition, in which the coating composition contains nanoparticles and a binder, and an amount of the nanoparticles is 40 to 70 wt% based on the total weight of the nanoparticles and the binder.

The nanoparticles may be spherical nanoparticles having an average diameter of 1 to 100 nm, 1 to 90 nm, 1 to 80 nm, 1 to 70 nm, 1 to 60 nm, 1 to 50 nm, or 5 to 50 nm. The nanoparticles include low conductive materials or insulation materials. Examples of the nanoparticles include silica particles, alumina particles, and the like.

An amount of the nanoparticles may be 40 to 70 wt% based on the total weight of the nanoparticles and the binder. Specifically, an amount of the nanoparticles having an average diameter of 10 to 20 nm may be 45 to 55 wt%.

The binder may include at least one selected from the group consisting of a radical curable compound and a cationic curable compound.

The radical curable compound maybe classified as a radical polymerizable monofunctional group monomer, a radical polymerizable polyfunctional group monomer, or a radical polymerizable oligomer.

Examples of the radical polymerizable monofunctional group monomer include acrylic acid, methyl acrylate, hexyl acrylate, 2-ethylhexyl acrylate, 2-hydroxyethyl acrylate, 2-hydroxypropyl acrylate, tetrahydrofurfuryl acrylate, phenoxyethyl acrylate, trioxyethyl acrylate, nonylphenoxyethyl acrylate, tetrahydrofurfuryloxyethyl acrylate, phenoxy diethyleneglycol acrylate, benzyl acrylate, butoxyethyl acrylate, cyclohexyl acrylate, dicyclopentanyl acrylate, dicyclopentenyl acrylate, glycidyl acrylate, carbitol acrylate, isobornyl acrylate, and the like.

Examples of the radical polymerizable polyfunctional group monomer include 1,6-hexanediol diacrylate, neopentyl glycol diacrylate, diethylene glycol diacrylate, tripropylene glycol diacrylate, dicyclopentanyl diacrylate, butylene glycol diacrylate, pentaerythritol diacrylate, trimethylolpropane triacrylate, propionoxide modified trimethylolpropane triacrylate, pentaerythritol triacrylate, ditrimethylolpropane tetraacrylate, dipentaerythritol hexaacrylate, caprolactone modified dipentaerythritol hexaacrylate, tetramethylolmethane tetraacrylate, and the like.

Examples of the radical polymerizable oligomer include polyester acrylate, polyether acrylate, urethane acrylate, epoxy acrylate, polyol acrylate, and the like.

Examples of the cationic curable compound include a cationic polymerizable epoxy compound, a vinyl ether compound, an oxetane compound, an oxolane compound, a cyclic acetal compound, a cyclic lactone compound, a thiirane compound, a thiovinylether compound, a spirortho ester compound, an ethylenic unsaturated compound, a cyclic ether compound, a cyclic thioether compound, and the like, and preferably, a cationic polymerizable epoxy compound, an oxetane compound, and the like.

Examples of the cationic polymerizable epoxy compound include a cresol novolac type epoxy resin, a phenol novolac type epoxy resin, and the like, and preferably a phenol novolac type epoxy resin.

Examples of the cationic polymerizable epoxy compound include an alicyclic epoxy compound, an aromatic epoxy compound, an aliphatic epoxy compound, and the like, and at least one selected from the aforementioned compounds may be used.

The term "alicyclic epoxy compound" herein means a compound including at least one alicyclic epoxy group. The term "alicyclic epoxy group" in the specification means a functional group including an epoxy group formed by two carbon atoms in an aliphatic saturated hydrocarbon ring.

Examples of the alicyclic epoxy compound include an epoxycyclohexylmethyl epoxycyclohexanecarboxylate-based compound, an epoxycyclohexane carboxylate-based compound of an alkanediol, an epoxy cyclohexylmethyl ester-based compound of a dicarboxylic acid, an epoxycyclohexylmethyl ether-based compound of polyethylene glycol, an epoxycyclohexylmethyl ether-based compound of an alkanediol, a diepoxytrispiro-based compound, a diepoxymonospiro-based compound, a vinylcyclohexene diepoxide compound, an epoxycyclopentyl ether compound, a diepoxy tricyclo decane compound, and the like.

Examples of the alicyclic epoxy compound include a difunctional epoxy compound, that is, a compound having two epoxy groups, and preferably a compound in which two epoxy groups are alicyclic epoxy groups, but are not limited thereto.

Examples of the aliphatic epoxy compound include an epoxy compound which has an aliphatic epoxy group without an alicyclic epoxy group. Examples of the alicyclic epoxy compound include a polyglycidyl ether of an aliphatic polyvalent alcohol; a polyglycidyl ether of an alkylene oxide adduct of an aliphatic polyvalent alcohol; a polyglycidyl ether of a polyester polyol of an aliphatic polyvalent alcohol and an aliphatic polyvalent carboxylic acid; a polyglycidyl ether of an aliphatic polyvalent carboxylic acid; a polyglycidylether of a polyester polycarboxylic acid of an aliphatic polyvalent alcohol and an aliphatic polyvalent carboxylic acid; a dimer, an oligomer, or a polymer obtained by vinyl polymerization of glycidyl acrylate or glycidyl methacrylate; or an oligomer or polymer obtained by vinyl polymerization of a vinyl-based monomer different from glycidyl acrylate or glycidyl methacrylate, and the like, preferably a polyglycidyl ether of an aliphatic polyvalent alcohol or an alkylene oxide adduct thereof, but are not limited thereto.

Examples of the aliphatic polyvalent alcohol include aliphatic polyvalent alcohols having 2 to 20 carbon atoms, 2 to 16 carbon atoms, 2 to 12 carbon atoms, 2 to 8 carbon atoms or 2 to 4 carbon atoms, for example, an aliphatic diol such as ethylene glycol, 1,2-propanediol, 1,3-propanediol, 2-methyl-1,3-propanediol, 2-butyl-2-ethyl-1,3-propanediol, 1,4-butanediol, neopentyl glycol, 3-methyl-2,4-pentanediol, 2,4-pentanediol, 1,5-pentanediol, 3-methyl-1,5-pentanediol, 2-methyl-2,4-pentanediol, 2,4-diethyl-1,5-pentanediol, 1,6-hexanediol, 1,7-heptanediol, 3,5-heptanediol, 1,8-octanediol, 2-methyl-1,8-octanediol, 1,9-nonanediol, or 1,10-decanediol; an alicyclic diol such as cyclohexane dimethanol, cyclohexanediol, hydrogenated bisphenol A, or hydrogenated bisphenol F; trimethylolethane; trimethylolpropane; hexytols; pentitols; glycerin; polyglycerin; pentaerythritol; dipentaerythritol; tetramethylolpropane; and the like.

Also, examples of the alkylene oxide include alkylene oxides having 1 to 20 carbon atoms, 1 to 16 carbon atoms, 1 to 12 carbon atoms, 1 to 8 carbon atoms or 1 to 4 carbon atoms, for example, ethylene oxide, propylene oxide, butylene oxide, and the like.

Also, examples of the aliphatic polyvalent carboxylic acid include, oxalic acid, malonic acid, succinic acid, glutaric acid, adipic acid, pimelic acid, suberic acid, azelaic acid, sebacic acid , dodecanedioic acid, 2-methylsuccinic acid, 2-methyladipic acid, 3-methyladipic acid, 3-methylpentanedioic acid, 2-methyloctanedioic acid, 3,8-dimethyldecanedioic acid, 3,7-dimethyldecanedioic acid, 1,20-eicosamethylene dicarboxylic acid, 1,2-cyclopentanedicarboxylic acid, 1,3-cyclopentanedicarboxylic acid, 1,2-cyclohexanedicarboxylic acid, 1,3-cyclohexanedicarboxylic acid, 1,4-cyclohexanedicarboxylic acid, 1,4-dicarboxylmethylenecyclohexane, 1,2,3-propanetricarboxylic acid, 1,2,3,4-butanetetracarboxylic acid, 1,2,3,4-cyclobutanetetracarboxylic acid, and the like, but are not limited thereto.

The aliphatic epoxy compound includes a compound having at least three epoxy groups, preferably three epoxy groups, without an alicyclic epoxy group, which is preferable in terms of a curing property, weather resistance, and a refractive index, but is not limited thereto.

The aromatic epoxy compound is an epoxy compound including an aromatic group in one molecule, and for example, includes a bisphenol type epoxy resin such as a bisphenol A-based epoxy, a bisphenol F-based epoxy, a bisphenol S epoxy, and a brominated bisphenol-based epoxy; a novolac type epoxy resin such as a phenolnovolac type epoxy resin and a cresolnovolac type epoxy resin; a cresol epoxy, a resorcinol glycidyl ether, and the like.

Examples of the cationic polymerizable oxetane compound include 3-ethyl-3-hydroxymethyl oxetane, 1,4-bis[(3-ethyl-3-oxetanyl)methoxymethyl]benzene, 3-ethyl-3-(phenoxymethyl)oxetane, di[(3-ethyl -3-oxetanyl)m ethyl] ether, 3-methyl-3-(2-ethylhexyloxymethyl)oxetane, phenolnovolac oxetane, and the like. Examples of the oxetane compound include "ARONE oxetane OXT-101," "ARONE oxetane Oxy-121," "ARONE oxetane OXT-211," "ARONE oxetane OXT-221," "ARONE oxetane OXT-212," and the like (manufactured by TOAGOSEI Co., Ltd.).

Examples of the cationic polymerizable compound include an epoxy compound, preferably an epoxy resin such as a cresol novolac type epoxy resin and a phenol novolac type epoxy resin.

The protective layer further includes a radical initiator or a cationic initiator as a component to initiate a curing reaction.

Examples of the radical initiator include a radical photoinitiator or a radical thermal initiator. Examples of the radical photoinitiator include initiators such as benzoine-based initiators, a hydroxyketone compound, an aminoketone compound or phosphine oxide compound, and preferably a phosphine oxide compound. Specific examples of the photoinitiator include benzoine, benzoine methylether, benzoine ethylether, benzoine isopropylether, benzoine n-butylether, benzoine isobutylether, acetophenone, dimethylamino acetophenone, 2,2-dimethoxy-2-phenylacetophenone, 2,2-diethoxy-2-phenylacetophenone, 2-hydroxy-2-methyl-1-phenylpropan-1-one, 1-hydroxycyclohexylphenylketone, 2-methyl-1 - [4-(methylthio)phenyl] -2-morpholino-propan-1-one, 4-(2-hydroxyethoxy)phenyl-2-(hydroxy-2-propyl)ketone, benzophenone, p-phenylbenzophenone, 4,4'-diethylaminobenzophenone, dichlorobenzophenone, 2-methylanthraquinone, 2-ethylanthraquinone, 2-t-butylanthraquinone, 2-aminoanthraquinone, 2-methylthioxanthone, 2-ethylthioxanthone, 2-chlorothioxanthone, 2,4-dimethylthioxanthone, 2,4-diethylthioxanthone, benzyldimethylketal, acetophenone dimethylketal, p-dimethylamino benzoic acid ester, oligo[2-hydroxy-2-methyl-1-[4-(1-methylvinyl)phenyl]propanone], bis(2,4,6-trimethylbenzoyl)-phenyl-phosphine oxide, 2,4,6-trimethylbenzoyl-diphenyl-phosphine oxide, and the like, but are not limited thereto.

Examples of the cationic initiator include cationic photoinitiators which discharge components capable of initiating cationic polymerization by radiation of activation energy rays or application of heat, that is, cationic photoinitiators or cationic thermal initiators.

Examples of the cationic photoinitiator include ionized cationic initiators such as onium salt or organometallic salt series; or non-ionized cationic photoinitiators such as organic silane or latent sulfonic acid series or other non-ionized compounds. Examples of the initiators of onium salt series include diaryliodonium salts, triarylsulfonium salts or aryldiazonium salts. Examples of the initiators of oganometallic salt series include iron arenes, or the like. Examples of the initiators of organic silane series include o-nitrobenzyl triaryl silyl ethers, triaryl silyl peroxides, acyl silanes, and the like. Examples of the initiators of latent sulfonic acid series include α-sulfonyloxy ketones, α-hydroxymethylbenzoine sulfonates, and the like, but are not limited thereto. Also, the cationic initiator includes a mixture of the initiator of an iodine series and a photosensitizer.

Examples of the cationic initiator include an ionized cationic photoinitiator, preferably an ionized cationic photoinitiator of an onium series, and more preferably an ionized cationic photoinitiator of a triarylsulfonium salt series, but are not limited thereto.

A thickness of the protective layer is suitably determined depending on use materials, a light transmittance rate required for a barrier film, and required durability. When a thickness of a protective layer formed on a barrier layer is very small, the protective layer does not satisfactorily protect the barrier layer. Meanwhile, when a thickness of the protective layer is increased, transparency of the film is decreased. Specifically, when insulation materials are used, such a problem becomes serious. When a thickness of the protective layer is increased, a thickness of a barrier film also increases. Accordingly, a thickness of the protective layer is preferably 0.5 nm to 100 nm, and more preferably 0.5 to 50 nm.

The aforementioned barrier film of the present application may have a water transmittance rate of 0.00085 to 0.00200 g/m²/day.

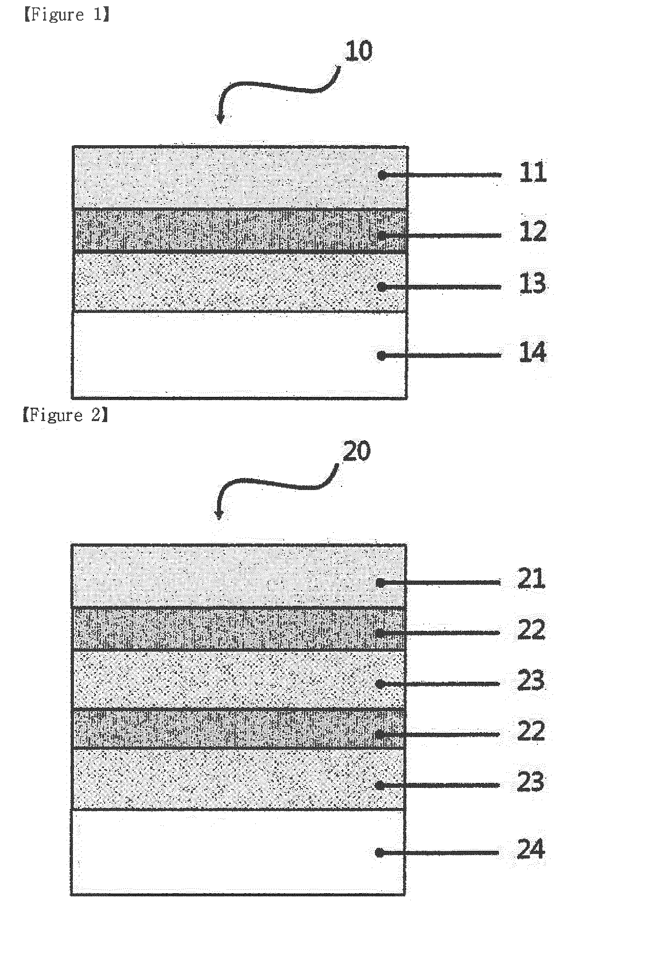

Fig. 1 is a cross-sectional schematic diagram of a barrier film according to one example of the present application. Referring to Fig. 1, a gas barrier film 10 according to one example of the present application sequentially includes a substrate layer 14, an intermediate layer 13, and a barrier layer 12. Also, a protective layer 11 is attached to the barrier layer 12 to further improve durability and a gas barrier property.

Fig. 2 is a cross-sectional schematic diagram of a barrier film according to another example of the present application. Referring to Fig. 2, a gas barrier film 20 according to another example of the present application sequentially includes a substrate layer 24, an intermediate layer 23, and a barrier layer 22. Also, the intermediate layer 23 and the barrier layer 22 are attached to each other and a protective layer 21 is attached to the barrier layer 22.

According to another aspect of the present invention, there is provided an barrier film forming apparatus, including a transferring unit including an unwinding roll provided to introduce a substrate layer into a processing region, one or more guide rolls provided to transfer the substrate layer, and a winding roll provided to recover the substrate layer; a treating region including a deposition device provided to form a barrier layer on the surface of the substrate layer by atomic layer deposition(ALD), and a protective layer forming device including a non-contact coating unit for forming a protective layer on the barrier layer formed on the substrate layer,
in which the transferring unit is provided such that the substrate layer introduced into the treating region by the unwinding roll is subsequently transferred through the deposition device and the protective layer forming device, and is recovered by the winding roll.

The barrier film forming apparatus of the present application includes a transferring unit and a processing region, in which the treating region includes a deposition device and a protective layer forming device. When the transferring unit is used, the substrate layer introduced into a treating region by the unwinding roll is subsequently transferred through the deposition device and the protective layer forming device, and is recovered by the winding roll. In the processing region, a precursor gas is deposited on the substrate layer by ALD in the deposition device to form a barrier layer, and a protective layer may be formed by a non-contact coating method on the barrier layer of the substrate layer in the protective layer forming device.

The treating region of the present application may further include an intermediate forming device provided to form an intermediate layer on the substrate layer. In this case, when the transferring unit is used, the transferring unit is provided such that the substrate layer introduced into the treating region by the unwinding roll is subsequently transferred through the intermediate layer forming device, the deposition device and the protective layer forming device, and recovered by the winding roll.

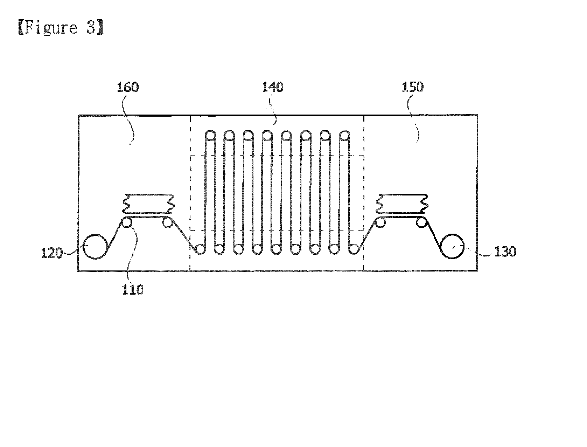

Fig. 3 is a cross-sectional diagram of a barrier film forming apparatus according to one example of the present application. As shown in Fig. 3, the barrier film forming apparatus includes the transferring unit and the treating region, the transferring unit includes an unwinding roll 120, a guide roll 110 and a winding roll 130, and the treating region includes an intermediate layer forming device 160, a deposition device 140, and a protective layer forming device 150.

An exemplary intermediate forming device may form an intermediate layer on the substrate layer using methods known in the art. According to formation of the intermediate layer, an intermediate layer coating composition may be applied continuously and by using coating methods including a dip coating process. The coating composition of an intermediate layer may use the aforementioned composition.

An exemplary treating region includes at least two regions (hereinafter referred to as first and second regions) and one or more flow-limiting paths may be formed in the first and second regions. The term "flow-limiting path" herein means a path through which a substrate may be transferred and through which a precursor gas which may be in respective regions does not move. Examples of a method of forming these paths will be described below. The respective regions are provided such that the precursor gas may be deposited on the surface of the substrate introduced through the flow-limiting path to form a barrier layer.

At least one of the guide rolls serving as a transferring unit is present in each of the first and second regions. The flow-limiting path is provided as a path formed such that the substrate is transferred at least one time through the first and second regions by the guide roll. The barrier film forming apparatus may include a precursor gas supplying unit to supply the precursor gas to the first and second regions. For example, a first precursor gas is supplied to the first region so that a first monolayer is formed on the substrate layer, a second precursor gas is supplied to the second region so that a second monolayer is formed on the substrate layer or the monolayer, and thereby a desirable barrier layer may be formed on the substrate layer. The first and second precursor gases are the same as or different from each other, and if necessary, processes of forming the first and second monolayers may be performed multiple times in consideration of a desired thickness. As will be described below, a third region in which a third monolayer is formed by a third precursor gas or purging is performed by an inert gas may be included in the apparatus.

An exemplary protective layer forming device may use a non-contact coating method when a protective layer is formed on the surface of the barrier layer formed on the substrate layer. The method minimizes contact with a processing layer(barrier layer), and thereby damage of the processing layer is prevented, and reduction of gas barrier property is suppressed.

Examples of the non-contact coating method include inkjet coating, capillary coating, slot die coating, plasma polymerization coating, sputtering coating, evaporation coating, CVD coating, iCVD coating, and the like.

Hereinafter, a deposition device, that is, a deposition device using atomic layer deposition(ALD) according to one example of the present application will be described.

An exemplary deposition device is separated into first and second regions. The first and second regions are separated by a wall such that precursor gases present in respective regions are not dispersed into each other. A flow-limiting path may be formed in the wall and the substrate layer may be transferred through the path. A discharging unit may be present in each region and a precursor gas may be discharged by the discharging unit.

The substrate layer introduced into the deposition device by the transferring unit is transferred sequentially and processed through the regions, transferred to the protective layer forming device and then recovered by the winding roll.

An exemplary deposition device may be provided such that the first and second regions are disposed sequentially, and the substrate layer is transferred through the upside of the region by the guide roll. In such a structure, a precursor gas may be discharged at the side of each region. A third region may be further present between these regions so long as the apparatus is formed such that the substrate layer is transferred sequentially through the first and second regions.

The deposition device may include the third region. The third region is, for example, a region into which an inert gas is introduced during a purging process of atomic layer deposition(ALD) or a region into which a precursor gas which is the same as or different from a gas introduced into the first and/or second regions is introduced. When the third region is present, the third region is connected to the first and/or second regions by the flow-limiting path, and the transferring unit may be provided such that the substrate is transferred to the second region through the third region from the first region (that is, an order of "first region → third region → second region").

Separate rolls are not present in the third region, but if necessary the guide roll may be present in the region. The plurality of third regions may be present. In other words, the plurality of third regions may be present between the first region and the second region, and the plurality of third regions may be separated by a wall in which a flow-limiting path is present. The substrate layer may be introduced into the second region through flow-limiting paths in the plurality of third regions from the first region.

When the third region is present, the transferring unit, for example, a guide roll, is provided such that the substrate is transferred through the first and second regions multiple times while it is transferred through the substrate in the third region every time.

In one example, the transferring unit may include the plurality of first guide rolls in the first region and a plurality of second guide rolls in the second region. At least one of the first guide rolls is provided to change a path of the substrate layer to the second region and at least one of the second guide rolls is provided to change a path of the substrate layer to the first region.

In the aforementioned apparatus, the substrate is transferred through respective regions by the transferring unit, and the precursor gas is deposited to form a monolayer or purging is performed in the region. The precursor gas may be supplied by a separate precursor gas supplying unit. The supplying unit includes a precursor gas generation source provided at the inside or outside of each region and further includes a pipe, a pump, a valve, a tank, and other known units to supply the precursor gas to a region. For example, when other regions such as the third region are present in addition to the first region and the second region, the precursor gas or the inert gas is introduced into the region by the supplying unit.

Each region may be a chamber to control internal pressure through gas discharge by the discharging unit or introduction pressure of the precursor gas or the inert gas. The chamber may be interfaced with other processing modules or devices for process control.

In the barrier film forming apparatus, in order to prevent a non-ALD reaction which may result from mixing a non-adsorbed precursor gas to the substrate present in each reaction with gases of other regions, a precursor gas of the region should be suppressed from moving to other regions. Thus, respective regions may be connected by the flow-limiting path or internal pressures may be controlled. Methods of constituting the flow-limiting path (hereinafter, simply referred to as a path) are not specifically limited and examples thereof include known methods. For example, each of the paths may be a slit which is thicker and wider than a substrate passing through the path. When a substrate passes through the path, the path allows very small space such that the substrate passes through the path smoothly. For example, the space may be specified in a range of several microns to several millimeters. The path may have a small, long tunnel shape such that a substrate may pass through, and if necessary may include a wiper to limit flow of gas passing through the path. The path may be a series of long, small paths, and the inert gas introduced into the third region may be directly injected into the path in the middle of the first and second regions, which helps to prevent mixing and moving of precursor gases.

There may be pressure differences between respective regions in order to prevent mixing of precursor gases. When a third region is present between the first region and the second region, an inert gas or a precursor gas is injected into the third region under higher pressure than each of the other regions, and thus mixing of gases may be prevented. For example, discharge flow of a gas is throttled or discharged manually to control internal pressure. In other examples, a region is pumped using a pump or other absorption source to produce a pressure difference. For example, pumps are connected to all regions, and the pressure of each region is controlled to produce a pressure difference. Moving of the precursor gas is prevented by controlling a relative flow rate of a gas and a pumping rate using a flow control valve or another flow control device. Also, a control device responding to a pressure sensor is used to control gas injection and discharge flow rates, which helps to maintain a desirable pressure difference.

According to still another aspect of the present invention, there is provided a method of preparing a barrier film using the aforementioned barrier film forming apparatus.

In the preparing method, a substrate layer is introduced into a deposition device in a treating region using an unwinding roll to form a barrier layer by atomic layer deposition(ALD), and the substrate layer on which the barrier layer has been formed is introduced into a protective layer forming device to form a protective layer on the barrier layer by a non-contact coating method, and then recovered by a winding roll.

The method further includes forming an intermediate layer on a substrate layer before introducing a substrate layer into a deposition device in a processing region.

According to still another aspect of the present application, there is provided a display device or a photovoltaic element including the barrier film in which durability and a gas barrier property are improved.

The barrier film of the present application may be used to protect products likely to be deteriorated by water, for example, display devices such as a liquid crystal display (LCD) or an organic light emitting diode (OLED) or photovoltaic elements such as solar cell.

### BRIEF DESCRIPTION OF THE DRAWINGS

The above and other objects, features and advantages of the present invention will become more apparent to those of ordinary skill in the art by describing in detail exemplary embodiments thereof with reference to the accompanying drawings, in which:
Fig. 1 is a diagram showing a barrier film according to one example of the present application;
Fig. 2 is a diagram showing a structure of a barrier film according to another example of the application; and
Fig. 3 is a diagram showing a cross-section of a barrier film forming apparatus according to one example of the present application.

### DETAILED DESCRIPTION OF EXEMPLARY EMBODIMENTS

Hereinafter, the present application will be described in detail through Examples which follow the present application and Comparative Examples which do not follow the present application, but scope of the present application is not limited to the following Examples.

### Example 1

A PET film having a thickness of 125 µm and a water vapor transmission rate (WVTR) of about 3 to 4 g/m²/day was used as a substrate layer. 50 g of tetraethoxy orthosilicate and 50 g of 3-glycidoxypropyltrimethoxysilane were diluted with 150 g of ethanol, 56.4 g of water and 1.6 g of 0.1 N HCl were added thereto, and then the mixture was reacted for one day at room temperature to form a coating composition solution in a sol state. The coating composition solution was coated on the substrate layer by bar coating, and thermally cured for 10 minutes at 120 °C to form an intermediate layer having a thickness of about 0.6 µm. Subsequently, a TiO₂ layer (barrier layer) was formed to have a thickness of about 15 nm on the intermediate layer by atomic layer deposition(ALD) using TiCl₄ and H₂O as precursor gas. Specifically, TiCl₄ and H₂O were each deposited and reacted in a pulse shape for 5 seconds on the intermediate layer to form a film, followed by purging with argon gas to remove un-reacted H₂O or byproducts. Such processes were set to one cycle, and the cycle was performed 40 times to form a barrier layer. Subsequently, a composition including condensate of pentaerythritol triacrylate and tetraethoxysilane was used as a coating composition to form a protective layer, and the coating composition was applied on the barrier layer in an inkjet method and cured to form a protective layer having a thickness of about 200 nm.

### Example 2

A barrier film was prepared in the same manner as in Example 1 except that a coating composition was coated by a capillary coating method.

### Example 3

A barrier film was prepared in the same manner as in Example 1 except that a coating composition was coated by a slot die coating method.

### Example 4

A barrier film was prepared in the same manner as in Example 1 except that a barrier layer having a thickness of about 12 nm was formed.

### Comparative Example 1

A barrier film was prepared in the same manner as in Example 1 except that a protective layer was formed by a bar coating method.

### Experiment 1

WVTR was measured for 100 hours at room temperature and 100% of relative humidity using Aquatran manufactured by Mocon, and results thereof for the barrier films prepared in Examples 1 to 4 and Comparative Examples 1 to 3 are described in Table 1.

**[Table 1]**

| | Example 1 | Example 2 | Example 3 | Example 4 | Comparative Example 1 |
|---|---|---|---|---|---|
| WVTR (unit: g/m²/day) | 0.0016 | 0.0016 | 0.0016 | 0.0016 | 0.0145 |

According to the present application, there is an effect in that a barrier film is provided in which a protective layer is formed on a barrier layer formed on a substrate by atomic layer deposition(ALD) according to a non-contact coating method, and thus contact with the barrier layer is minimized and damage of the barrier layer is prevented, and a gas barrier property is suppressed from reducing, thus improving durability and a gas barrier property.

Accordingly, the barrier film of the present application is used for products likely to be deteriorated by water, for example, display devices such as an LCD or an OLED, or photovoltaic elements such as a solar cell.

It will be apparent to those skilled in the art that various modifications can be made to the above-described exemplary embodiments of the present invention without departing from the spirit or scope of the invention. Thus, it is intended that the present invention covers all such modifications provided they come within the scope of the appended claims and their equivalents.

### Description of Reference Numerals

- 10, 20:: Barrier film structure
- 11, 21:: Protective layer
- 12, 22:: Barrier layer
- 13, 23:: Intermediate layer
- 14, 24:: Substrate layer

## Claims

1. A method of preparing a barrier film comprising:
forming a barrier layer on a substrate layer by atomic layer deposition(ALD), and
coating the barrier layer with a coating composition by a non-contact coating method to form a protective layer.

2. The method of claim 1, wherein the barrier layer includes TiO₂, SiO₂, Al₂O₃, ZnO, ZnS, HfO₂, HfON, AlN, Si₃N₄, SiON, or SnO₂.

3. The method of claim 1, wherein the barrier layer is formed to have a thickness of 5 nm to 20 nm.

4. The method of claim 1, wherein the non-contact coating method includes inkjet coating, capillary coating, slot die coating, plasma polymerization coating, sputtering coating, evaporation coating, chemical vapor deposition (CVD) coating, or iCVD coating.

5. The method of claim 1, wherein the coating composition includes, as a binder, at least one selected from the group consisting of a condensed curable compound, a thermosetting compound, a radical curable compound, and a cationic curable compound.

6. The method of claim 5, wherein the coating composition contains nanoparticles and an amount of the nanoparticles is 40 wt% to 70 wt% based on the total weight of the nanoparticles and the binder.

7. The method of claim 6, wherein the nanoparticles are spherical nanoparticles.

8. The method of claim 6, wherein the nanoparticles have an average diameter of 1 to 100 nm.

9. The method of claim 6, wherein the nanoparticles are silica particles or alumina particles.

10. The method of claim 1, further comprising forming an intermediate layer on the substrate layer before forming the barrier layer.

11. A barrer film forming apparatus comprising:
a transferring unit including an unwinding roll provided to introduce a substrate layer into a processing region, one or more guide rolls provided to transfer the substrate layer, and a winding roll provided to recover the substrate layer; and
a treating regionincluding a deposition device provided to form a barrier layer on the surface of the substrate layer by atomic layer deposition(ALD), and a protective layer forming device including a non-contact coating unit for forming a protective layer on the barrier layer formed on the substrate layer,
wherein the transferring unit is provided such that the substrate layer introduced into the treating region by the unwinding roll is subsequently transferred through the deposition device and the protective layer forming device, and recovered by the winding roll.

12. The apparatus of claim 11, wherein the non-contact coating unit is an inkjet coating device, a capillary coating device, a slot die coating device, a plasma polymerization device, a sputtering device, an evaporation device, a CVD coating device, or an iCVD coating device.

13. The apparatus of claim 11, wherein the treating region further includes an intermediate layer forming device provided to form an intermediate layer on the substrate layer, and the transferring unit is provided such that the substrate layer introduced into the treating region by the unwinding roll is subsequently transferred through the intermediate layer forming device, the deposition device, and the protective layer forming device, and recovered by the winding roll.

14. A method of preparing a barrier film using the apparatus of claim 11, comprising:
introducing a substrate layer into a deposition device in a treating region using an unwinding roll serving as a transferring unit to form a barrier layer by atomic layer deposition(ALD) in the apparatus;
introducing the substrate layer on which the barrier layer has been formed into a protective layer forming device to form a protective layer on the barrier layer by a non-contact coating unit, and
recovering the substrate layer by a winding roll.
